# EUROPEAN PATENT APPLICATION

(11) **EP 2 500 942 A1**
(43) Date of publication of application: **19.09.2012**
(21) Application number: 10829701.1
(22) Date of filing: 09.11.2010
(51) Int. Cl.: H01L 27/14, H04N 5/369

(54) **SOLID-STATE IMAGE PICKUP DEVICE AND METHOD FOR MANUFACTURING SAME**

(30) Priority: 11.11.2009 JP 2009258226
(71) Applicant: Panasonic Corporation, Kadoma-shi Osaka 571-8501 (JP)
(72) Inventor: YAMADA, Kiyohiko, Chuo-ku, Osaka 540-6207 (JP); NAKAGIRI, Yasushi, Chuo-ku, Osaka 540-6207 (JP)
(74) Representative: Grünecker, Kinkeldey, Stockmair & Schwanhäusser
(86) International application number: PCT/JP2010/006574
(87) International publication number: WO 2011/058737

(57) **Abstract**

There is provided a solid-state imaging device with reduced size and thickness.

An optically opaque pattern has been routed on a glass substrate, and solid-state imaging elements are flip-mounted on the substrate. In contrast, the solid-state imaging device of the present invention uses an optically transparent conductive pattern, whereby traces can be formed on a light receiving. Thus, a degree of freedom of trace routing is enhanced, and the size of the solid-state imaging device can be substantially reduced.

## Description

### Technical Field

The present invention relates to a solid-state imaging device, and more particularly, a solid-state imaging device for realizing a small and thin solid-state imaging device.

### Background Art

An imaging device produced by so-called face-down mounting has been proposed. In the face-down mounting, bumps made of metal such as Au are formed on connection terminals of a solid-state imaging element separated from a glass substrate, and the bumps are connected to predetermined terminals on the glass substrate (see, for example, Patent Document 1 and Patent Document 2).

However, due to size reduction and sophistication of a portable phone, there is a need to reduce a size of a camera module, particularly to a reduction in height dimension and footprint thereof.

As a measure for satisfying the need, there has been pursued a design for reducing a dimension of an optical system (a dimension between the imaging element and a lens top surface) occupying a great part of the height of the camera module by reducing a pixel size of the solid-state imaging element.

In order to reduce the footprint and cost of the camera module, there has been pursued an improvement to a chip circuit configuration of a CCD image sensor and a device (a digital signal processor: a DSP) configured to electrically correct an output signal of the CCD image sensor so as to correct a resolution, a color tone, shading, etc., of a camera. In addition, there has become widely used a so-called system-on-chip (SOC) solid-state imaging element including a circuit having a DSP function disposed around a solid-state imaging element manufactured by use of a CMOS process.

### Related Art Documents

### Patent Documents

Patent Document 1: JP-A-6-204442
Patent Document 2: JP-A-7-231074

### Summary of the Invention

### Problem to be Solved by the Invention

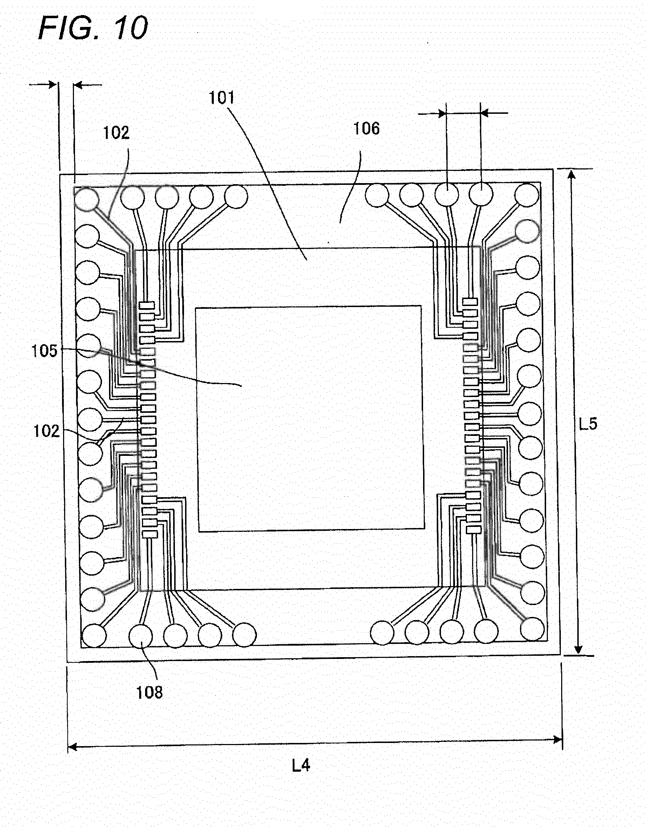

Even when a glass substrate is used as a light-transmitting substrate 101, a trace (a metal trace) 102 using a metal film formed by a thin film deposition process or an electroless plating process has been used. In the light-transmitting substrate 101, since light hardly passes through the metal film, the trace 102 has to be formed at regions except a light receiving area 105 of a solid-state imaging element 106 (see Fig. 10). When compared with a CCD, a CMOS generally has a larger number of terminals (solder balls 108) connected to a substrate, whereby a pad pitch is narrow. Accordingly, an area of the light-transmitting substrate 101 significantly becomes larger than an area of the actual solid-state imaging element 106.
Consequently, there has been a problem of an increase in the footprint of the camera module substrate, which can not satisfy the need for reduction of the size and thickness of the solid-state imaging device can not be satisfied.
The present has been made in view of the above circumstances, and an object thereof is to provide a solid-state imaging device with reduced size and thickness.

### Means for Solving the Problem

In order to solve the problem, a solid-state imaging device of the present invention uses an optically-transparent conductive pattern as a trace, in place of the related art technique of forming optically opaque patterns over the glass substrate and flip-mounting the solid-state imaging element. Consequently, since the present invention uses the optically-transparent conductive pattern, the trace can be routed over the light receiving area, thereby increasing a degree of freedom of trace routing and substantially reduce the size of the solid-state imaging device.
The solid-state imaging device of the present invention includes a terminal electrode and an inside electrode which are formed on a grass substrate. The terminal electrode is configured to output an electric signals to outside, and the inside electrode provided used for bonding the solid-state imaging element to the glass substrate by a conductive adhesive. The terminal electrodes and the inside electrodes are connected by an optically-transparent conductive trace formed across an upper surface of a light receiving area of the solid-state imaging element. A region of a gap between the solid-state imaging element and the glass substrate except the light receiving area of the solid state imaging element is sealed with a sealing resin.

Specifically, a solid-state imaging device of the present invention includes: a light-transmitting substrate including a terminal electrode for external connection, an inside electrode for bonding a solid-state imaging element, and a trace that connects the terminal electrode to the corresponding inside electrode; and the solid-state imaging element which is placed such that a light receiving area opposes the light-transmitting substrate and which is connected to the inside electrode, wherein the trace is made of a light-transmitting conductive film at least in a region opposing the light receiving area of the solid-state imaging element.
In the configuration, the trace connecting the inside electrode to the terminal electrode is made of the light-transmitting conductive film, and the trace is provided on the light receiving area. Consequently, the degree of freedom of trace routing is increased, and the size of the solid-state imaging device can be substantially reduced.

According to the present invention, in the solid-state imaging device, a region of a gap between the solid-state imaging element and the light-transmitting substrate except the light receiving area of the solid-state imaging element is filled with a sealing resin.
With this configuration, a moisture content can be prevented from entering into the solid-state imaging element, and an additional protective material is not required. Therefore, the size of the solid-state imaging device can be reduced.

According to the present invention, in the solid-state imaging device, the light receiving area of the solid-state imaging element has a rectangular shape, and the trace obliquely runs across a corner portion of the rectangular shape.
In the configuration, the traces are formed in a periphery of the light receiving area of the solid-state imaging element, and a degree of freedom of trace routing can be enhanced without adversely affecting an imaging characteristic of the solid-state imaging element.

According to the present invention, in the solid-state imaging device, the terminal electrode is arranged along a side of the light-transmitting substrate.
In the configuration, the terminal electrode formation area can be increased, and mounting work is improved.

According to the present invention, in the solid-state imaging device, the inside electrode is arranged along opposing two sides of the solid-state imaging element.
According to the configuration, the trace is formed so as to run across the light receiving area of the solid-state imaging element. For this reason, even when the inside electrode is formed along two opposing sides and when the terminal electrode is formed along the other sides, the length of the traces that connect the inside electrode to the terminal electrode can be reduced, and the traces with high reliability can be provided.

According to the present invention, in the solid-state imaging device, the light-transmitting substrate is a glass substrate.
The configuration prevents entry of a moisture content, to thus realize chemical stability. Therefore, it is possible to provide a highly-reliable solid-state imaging device.

According to the present invention, in the solid-state imaging device, at least an upper surface of the trace opposing the light receiving area of the solid-state imaging element is made of a light-transmitting conductive film, and in a region other than the light receiving area, the trace is made of a metallic film.
In the configuration, the trace is made of a light-transmitting conductive film in the light receiving area. In an area other than the light receiving area, the trace is made of a metallic film. As a result, it is possible to provide a semiconductor device with a high degree of design freedom while an increase in trace resistance is prevented to the maximum extent.

According to the present invention, in the solid-state imaging device, the light-transmitting electrode is made of an indium tin oxide layer.
With this configuration, it is possible to obtain superior transparency at low resistance.

According to the present invention, in the solid-state imaging device, a plurality of solid-state imaging elements are placed on the light-transmitting substrate.
With this configuration, even when the trace becomes complicate, the trace can be efficiently routed at the minimum trace length. Therefore, a footprint required for trace routing is reduced, which can accomplish size reduction. Further, a reduction in trace resistance can increase operating speed.

According to the present invention, in the solid-state imaging device, the plurality of solid-state imaging elements are integrated on a single substrate, and in a region opposing the solid-state imaging elements, the trace is provided so as to oppose a trace area that surrounds the light receiving areas of the respective solid-state imaging elements.
According to the configuration, the trace is formed, for example, on the charge transfer unit, whereby trace routing can be facilitated while a reduction in the amount of received light is prevented.

According to present invention, in the solid-state imaging device, each of the solid-state imaging elements includes a photoelectric conversion unit including a photodiode and a charge transfer unit configured to transfer electric charges produced by the photoelectric conversion unit, and in the region opposing the solid-state imaging elements, the trace is formed in a region opposing the charge transfer units.

According to the present invention, in the solid-state imaging device, the light-transmitting substrate includes an optical filter configured to permit transmission of light having a specific wavelength band and a light shielding film formed in a region corresponding to a boundary between a plurality of imaging areas.
In the configuration, the light-transmitting substrate includes both the optical filter and the light shielding film that defines the imaging areas. Hence, a small and thin solid-state imaging device can be provided.

According to the present invention, a method for manufacturing the solid-state imaging device includes: a step of positioning a projecting electrode formed at a connection terminal of the solid-state imaging elements to the inside electrode of the light-transmitting substrate and bonding the projecting electrode to the inside electrode by a conductive adhesive; and a step of sealing the region of the solid-state imaging element except the light receiving area thereof.
According to the method, it is possible to easily produce a highly-reliable solid-state imaging device.

According to the present invention, in the method for manufacturing the solid-state imaging device, the light-transmitting substrate includes: the glass substrate; the optical filter which is formed on a surface of the glass substrate opposing an adhesive surface of the solid-state imaging element and which is configured to permit transmission of light having the specific wavelength band; and the light shielding film formed in the region corresponding to the boundary between the plurality of imaging areas, and the sealing step includes a step of sealing the region, except the light receiving area of the solid-state imaging element, with a photo-curable resin that causes a curing reaction at the transmission wavelength band of the optical filter after the bonding step.
With this configuration, a highly reliable solid-state imaging device can be produced without entry of a resin into the light receiving areas.

### Advantages of the Invention

As described above, according to the present invention, the traces are formed by use of an optically transparent conductive pattern, thereby making it possible to route the traces over the light receiving areas. This results in an increase in degree of freedom of trace routing, which makes it possible to reduce the size of the solid-state imaging device.

### Brief Description of the Drawings

Fig. 1 is a schematic diagram showing a top view of a solid-state imaging device of a first embodiment of the present invention.
Fig. 2 is a cross sectional view of the solid-state imaging device of the first embodiment.
Fig. 3 is a partial exploded perspective view of the solid-state imaging device of the first embodiment.
Fig. 4 is a partial assembly diagram of the solid-state imaging device of the first embodiment.
Fig. 5 is a partial exploded perspective view of the solid-state imaging device of the first embodiment.
Fig. 6 is an assembly-completed diagram of the solid-state imaging device of the first embodiment.
Fig. 7 is a cross sectional view of an assembly-completed diagram of the solid-state imaging device of the first embodiment.
Fig. 8 is a schematic diagram of a top view of a solid-state imaging device of a third embodiment of the present invention.
Fig. 9 is an external view of a compound lens using the solid-state imaging device of the third embodiment.
Fig. 10 is an explanatory top view of a related art solid-state imaging device.

### Mode for Carrying Out the invention

Embodiments of the present invention are described below in detail by reference to the drawings.

### (First Embodiment)

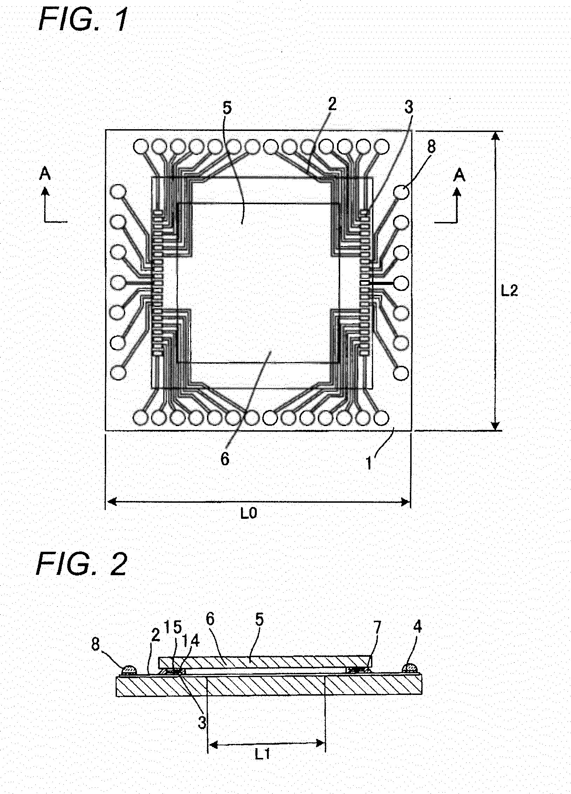

A solid-state imaging device of a first embodiment is described by reference to Figs. 1 through 7.

The solid-state imaging device of the first embodiment of the present invention uses an optically transparent conductive pattern as a material of traces 2 that connect terminal electrodes for outputting an electric signal to the outside to inside electrodes 3 for bonding a solid-state imaging element 5 to a glass substrate serving as a light-transmitting substrate 1. The traces 2 can be routed on a light receiving area 6, so that a degree of freedom of the traces 2 can be increased, to thus substantially reduce the size of the solid-state imaging device.

Specifically, as shown in Figs. 1 and 2, in the solid-state imaging device, terminal electrodes 4 that output electric signals to the outside, the inside electrodes 3 for bonding the solid-state imaging elements 5 to the glass substrate by means of a conductive adhesive, and the optically-transparent conductive traces 2 are formed on a glass substrate serving as the light-transmitting substrate 1. The terminal electrodes 4 and the inside electrodes 3 are connected by the optically-transparent conductive traces 2 that run across an upper surface of the light receiving area 6 of the solid-state imaging element 5, i.e., a light-transmitting conductive film. Further, a region of gap between the solid-state imaging element 5 and the light-transmitting substrate 1 except the light receiving area 6 of the solid state imaging element 5 is sealed with a sealing resin 10. The solid-state imaging element includes: a photoelectric conversion unit including a photodiode; and a charge transfer unit configured to transfer electric charges generated by the photoelectric conversion unit. Fig. 2 is a cross sectional view taken along line A-A shown in Fig. 1.

Specifically, the solid-state imaging device of the present invention includes the light-transmitting substrate 1 and the solid-state imaging element 5 as shown in the schematic diagram of top view shown in Fig. 1. The light-transmitting substrate 1 includes the external connection terminal electrodes 4, the inside electrodes 3 used for bonding the solid-state imaging element, and the traces 2 made of a light-transmitting conductive film for connecting the terminal electrodes 4 with the corresponding inside electrodes 3. The solid-state imaging element 5 is arranged such that the light receiving area opposes the light-transmitting substrate 1 and also connected to the inside electrodes 3. Moreover, the traces 2 are made of a light-transmitting conductive film in at least a region opposing the light receiving area 6 of the solid-state imaging element 5. Reference numeral 8 designates solder balls serving as bumps connected to the respective terminal electrodes 4.

As shown in Fig. 2, in the solid-state imaging device of the present embodiment, the solid-state imaging element (chip) 5 including a light receiving area, i.e., the imaging area 6, is provided on a silicon substrate serving as a semiconductor substrate. The inside electrodes 3, the terminal electrodes 4, and the traces 2 made of a light-transmitting conductive film such as indium tin oxide (ITO) are formed on a glass substrate serving as the light-transmitting substrate 1.

The light-transmitting conductive film is formed, for example, by a method described below.
First, a photosensitive resin film is formed by means of a wet coating technique.
After having been pre-baked, the resin film is exposed to UV radiation using a high voltage electric discharge lamp, or the like through a predetermined mask. The resin film is then developed and sintered, whereby the traces 2 made of indium tin oxide (ITO), or the like, are formed.

The solid-state imaging element 5 and the traces 2 of the light-transmitting substrate 1 are overlapped so as to oppose each other. The solid-state imaging element 5 and the inside electrodes 3 connected to the traces 2 are electrically connected electrical connection portions 14 (a connection portions between electrode pads forming the inside electrodes 3 of the glass substrate and metallic bumps 15 of the solid-state imaging element). A periphery of the electrical connection portions 14 is sealed with an insulating sealing resin 7.

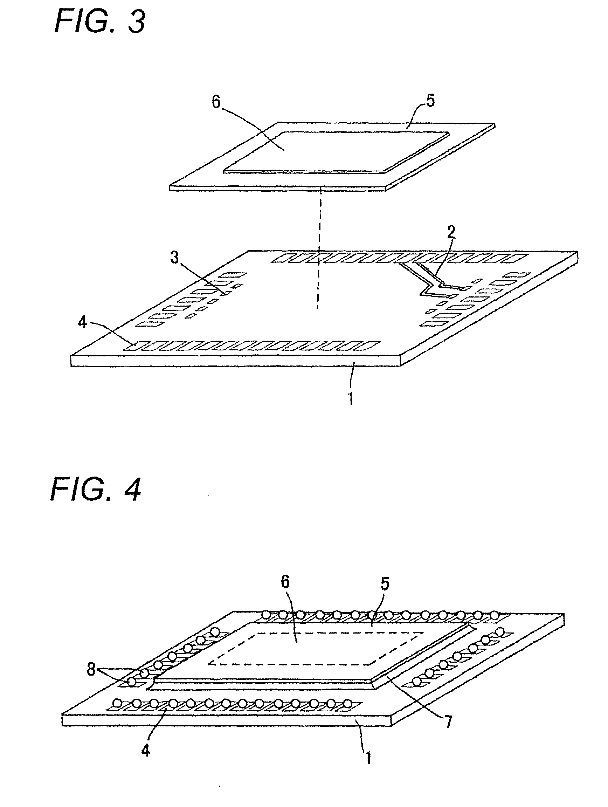

Fig. 3 is a partially broken fragmentary exploded perspective view of the solid state imaging device of the first embodiment. As shown in Figs. 3 and 2, the electrode pads forming the inside electrodes 3 and the terminal electrodes 4 are formed on a light-transmitting glass substrate serving as the light-transmitting substrate 1. The inside electrodes 3 and the terminal electrodes 4 are routed over the surface of the glass substrate and electrically connected together. The inside electrodes 3 and the terminal electrodes 4 are used for connection with the solid-state imaging element 5 and provided in correspondence with the metal bumps 15 formed around an imaging area (the light receiving area) 6 of the solid-state imaging element 5. The inside electrodes and the terminal electrodes can be connected directly to the corresponding imaging area by means of a trace. The terminal electrodes 4 are used for electrical connection with a printed wiring board that takes a signal of the solid-state imaging element 5 to the outside. As described previously, the solid-state imaging element 5 is structured in such a way that the imaging area (the light receiving area) 6 is formed on a silicon substrate. The metal bumps 15 are formed on electrical wiring pads (not shown) on a back surface of the solid-state imaging element (substrate) 5, and the electrode pads forming the inside electrodes 3 are mounted. In order to assure adhesion strength and electrical connection reliability of the solid-state imaging element 5, the insulating sealing resin 7 is injected into the periphery of the electric connection portions 14 between the metal bumps 15 and the electrode pads (3).

Fig. 4 is a partial assembly drawing of the solid-state imaging device of the first embodiment.
The solid-state imaging element 5 is mounted on the light-transmitting substrate 1, and the insulating sealing resin 7 is injected therebetween. As is apparent from Figs. 2 and 4, the insulating sealing resin 7 does not leak into the imaging area and surrounds the periphery of the electrical connection portions 14 of the metal bumps 15 of the solid-state imaging element 5, thereby assuring bonding strength. The solder balls 8 are attached onto the electrode pads of the respective terminal electrodes 4.

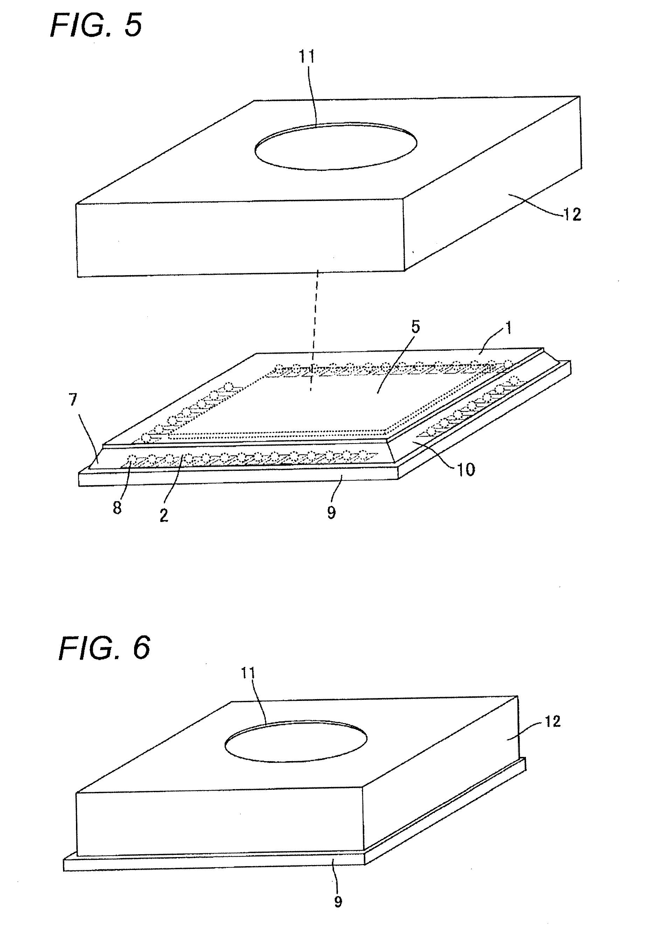

Fig. 5 is a partial exploded perspective view of the solid-state imaging device of the first embodiment.
The light-transmitting substrate 1 on which the solid-state imaging element 5 and the solder balls 8 are mounted is inverted and solder-mounted to a printed wiring board 9, and the strength of the light-transmitting substrate 1 is reinforced by an underfill (a sealing resin) 10. Here, the insulating sealing resin 7 injected in a preceding process is exposed outside. In this state, a lens housing 12 including a plurality of lenses 11 is prepared from above. A surface of the light-transmitting substrate 1 where the solid-state imaging element 5 is not mounted is taken as a reference surface, and the lens housing 12 is mounted on the reference surface. The lens housing 12 is integrated with the printed wiring board 9, whereby a solid-state imaging device is completed.

In the embodiment, the solid-state imaging element is solder-mounted directly to the printed wiring board by the solder balls. However, an indirect conduction method for placing a conductive member sandwiched between a printed wiring board and a solid-state imaging element may be used in view of the thickness of the solid-state imaging element. Alternatively, a method for grinding a printed wiring board or drilling a through hole may be used.

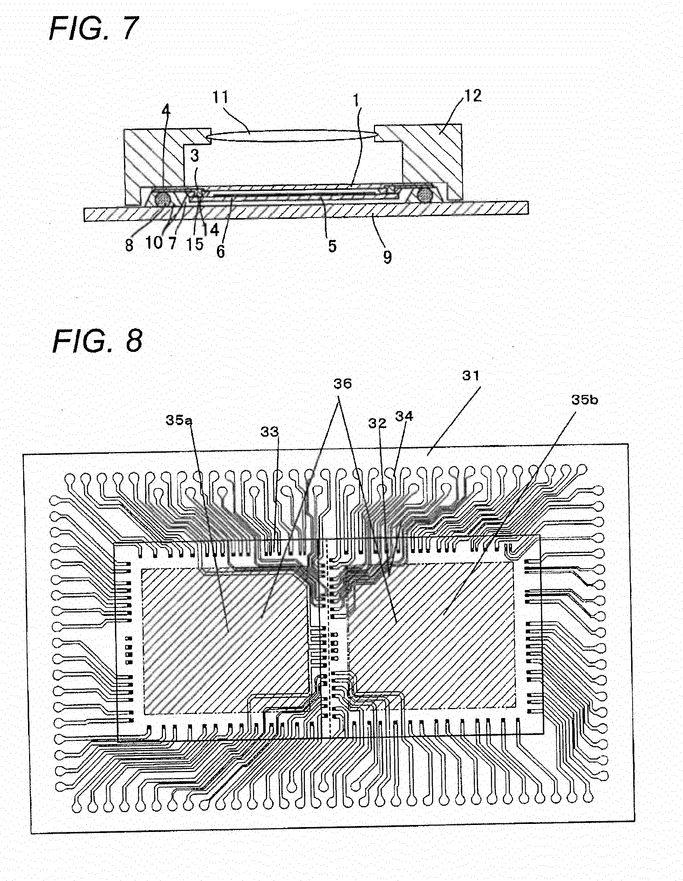

Fig. 6 is an assembly-completed diagram of the solid-state imaging device of the first embodiment. Fig. 7 is a cross-sectional assembly-completed diagram of the solid state imaging device of the first embodiment.
The light-transmitting substrate 1 is mounted on the surface of the printed wiring board 9 through the solder balls 8. Strength of a periphery of the solder balls 8 is reinforced by the underfill 10. The solid-state imaging element 5 including the imaging area (the light receiving area) 6 having integration of two imaging areas is mounted on the light-transmitting substrate 1 through the electrical connection portions 14. The insulating sealing resin 7 is injected in full measure into a periphery of the light-transmitting substrate 1 and cured. Further, in a manufacturing method of the present invention to be described later, the insulating sealing resin 7 does not leak to the imaging area (the light receiving area) 6 of the solid-state imaging element 5.

A surface of the light-transmitting substrate 1 that is not equipped with the solid-state imaging element 5 is taken as a reference surface, and the lens housing 12 include the lenses 11 is mounted on the reference surface.

Since the imaging device has such a structure, optical information captured by the compound lens 11, i.e., light does not leak to an adjoining area and enters the imaging area (the light receiving area) 6 of the solid-state imaging element 5 mounted on the light-transmitting substrate 1 with superior accuracy while a distance from the light-transmitting substrate 1 is made constant with superior accuracy. Moreover, adhesion strength between the solid-state imaging element 5 and the light-transmitting substrate 1 and adhesion strength between the light-transmitting substrate 1 and the printed wiring board 9 are sufficiently reinforced and assured by the insulating sealing resin 7 and the underfill 10. The solid-state imaging element 5 is connected to the light-transmitting substrate 1 by the metal bumps 15 provided on the electrode wiring pads (not shown) provided around the imaging area in correspondence with the imaging area without routing traces within the solid-state imaging element 5. Therefore, the solid-state imaging element can be connected directly to the traces on the light-transmitting substrate 1 from the imaging area (the light receiving area) 6. Accordingly, bumps will not concentrate on the periphery of the solid-state imaging element substrate (chip), and it also becomes possible to prevent occurrence of noise caused by useless routing of traces.

The light-transmitting substrate 1 has L0 wide and L2 long with respect to a light receiving area L1. When compared with a related art light-transmitting substrate 101 having L4 wide and L5 long as shown in Fig. 8, the length of the light-transmitting substrate 1 is substantially equal to the light-transmitting substrate 101. However, the width L0 of the present invention is significantly smaller than the width L4 of the related art substrate (L0 < L4, L2 ≈ L5).
That is, implementation of the present invention is understood to be effective for reducing the size of the solid-state imaging device.

A substrate coated with an optical filter film or an antireflection film may be used as the light-transmitting substrate 1. In this case, an optical characteristic can be enhanced to a greater extent.

In the solid-state imaging device, the terminal electrodes are configured so as to obliquely run across a corner portion of the rectangular light receiving area of the solid-state imaging element. Hence, even when the inside electrodes arranged along the respective sides of the light-transmitting substrate are routed along opposing two sides of the solid-state imaging element, a degree of freedom of trace routing can be enhanced without adversely affecting an imaging characteristic of the solid-state imaging element.

According to the present invention, in the solid-state imaging device, a plurality of solid-state imaging elements are mounted on the light-transmitting substrate.
With this configuration, even when traces become complicate, the traces can be efficiently routed at the minimum trace length. Therefore, a footprint required for trace routing can be reduced, thereby reducing the size of the solid-state imaging device. In addition, a reduction in trace resistance can increase operating speed.

In the present invention, the plurality of solid-state imaging elements may be integrated on a single substrate in the solid-state imaging device. In this case, in a region opposing the solid-state imaging element, the traces are routed so as to oppose a trace area surrounding the light receiving area of the solid-state imaging element.
In the configuration, for example, traces are formed on an electric charge transfer unit, whereby trace routing can be facilitated while a reduction in a quantity of received light is prevented.

In the present invention, for manufacturing the solid-state imaging device, projecting electrodes formed at connection terminals of the solid-state imaging elements are positioned to the inside electrodes of the light-transmitting substrate, the projecting electrodes are bonded to the inside electrodes by a conductive adhesive, and the region of the solid-state imaging element except the light receiving area thereof is sealed. At the sealing operation, the region of the solid-state imaging element except the light receiving area thereof is sealed with a photo-setting resin that causes a curing reaction at a transmission wavelength band of the optical filter.
According to the method, it is possible to form a highly-reliable solid-state imaging device without entry of a resin into the light receiving area.

### (Second Embodiment)

A second embodiment of the present invention is now described.
In the previous embodiment, the traces on the glass substrate are made of a light-transmitting conductive film. However, at least upper surfaces of the traces opposing the light receiving area of the solid-state imaging element may be made of a light-transmitting conductive film. In the present embodiment, traces in a region of the solid-state imaging element except the imaging area (the light receiving area) are made of a metallic film.
According to the configuration, traces in the light receiving area are made of a light-transmitting conductive film. In the other regions, the traces are made of a metallic film, whereby a semiconductor device exhibiting a high degree of design freedom can be provided while an increase in trace resistance is reduced to the maximum extent.

### (Third Embodiment)

A third embodiment of the present invention is now described.
Although the previous embodiments describe the case in which the number of the light receiving area is one, the present embodiment describes a case in which a solid-state imaging element having a plurality of imaging areas (light receiving areas) is used.
In the present embodiment, a plurality of solid-state imaging elements are integrated on a single substrate, and in the area opposing the solid-state imaging element, the traces are routed so as to oppose a trace area surrounding the light receiving areas of the solid-state imaging element.

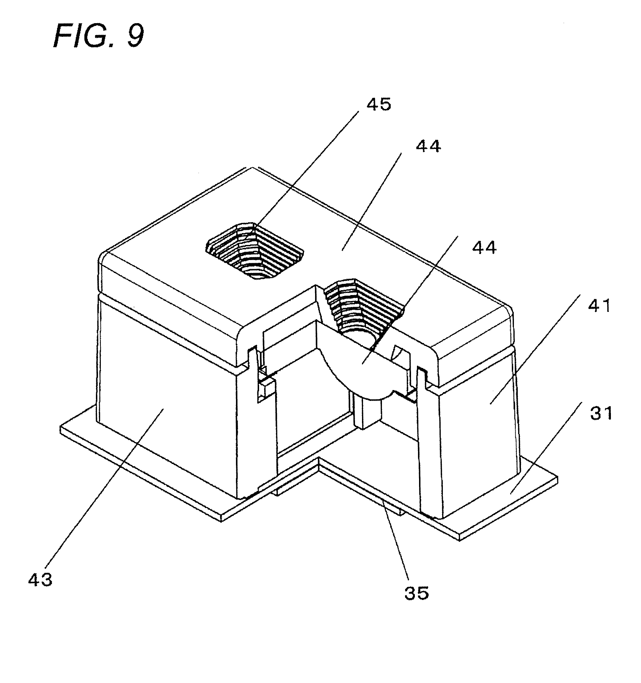

A solid-state imaging device of the third embodiment is described by reference to Figs. 8 and 9.
As illustrated in the top view of the substrate shown in Fig. 8, the solid-state imaging device of the third embodiment of the present invention includes two solid-state imaging elements 35a and 35b placed on top of a glass substrate serving as a light-transmitting substrate 31. An optically transparent conductive pattern is used as a material of traces that connect terminal electrodes 34, which are configured to output electric signals to the outside of the chip, to inside electrodes 33 for bonding the solid-state imaging elements 35a and 35b to the light-transmitting substrate 31. Traces can be routed over light receiving areas 36, to thus increase a degree of freedom of traces 32. A size of a solid-state imaging device is substantially reduced.
Specifically, as shown in Fig. 8, in the solid-state imaging device includes the terminal electrodes 34 for outputting electrical signals to the outside, the inside electrodes 33 for bonding the solid-state imaging elements 35a and 35b to the glass substrate by means of a conductive adhesive, and the optically-transparent conductive traces 32, i.e., a light-transmitting conductive film, that run across the upper surfaces of the light receiving areas 36 of the respective solid-state imaging elements 35a and 35b and connect the terminal electrodes 34 and the inside electrodes 33 on the glass substrate are provided on a glass substrate serving as the light-transmitting substrate 31. A region of a gap between the solid-state imaging elements 35a and 35b and the light-transmitting substrate 31, except the light receiving areas 36 of the respective solid-state imaging elements 35a and 35b, is sealed by a housing 50. Each of the solid-state imaging elements 35a and 35b includes a photoelectric conversion unit including a photodiode and a charge transfer unit configured to transfer electric charges produced by the photoelectric conversion unit. Fig. 9 is an oblique view showing a compound camera using the solid-state imaging device shown in Fig. 8.

Specifically, as shown in a schematic explanatory external view shown in Fig. 9, the compound camera of the present invention includes: a glass substrate serving as the light-transmitting substrate 31 including the terminal electrodes 34 for external connection, the inside electrodes 33 for bonding the solid-state imaging elements, and the traces 32 that are made of a light-transmitting conductive film such as indium tin oxide (ITO) for connecting the terminal electrodes 34 to the corresponding inside electrodes 33; and the solid-state imaging elements 35a and 35b which are placed on the glass substrate such that the light receiving areas 36 of the respective solid-state imaging elements 35a and 35b oppose the glass substrate and which are connected to the inside electrodes 33. The traces 32 are made of a light-transmitting conductive film at least in a region opposing the light receiving areas 36 of the respective solid-state imaging elements 35a and 35b.

As shown in Fig. 9, in a compound camera using the solid-state imaging device of the present embodiment, the light receiving areas 36, i.e., two imaging areas, are formed on a silicon substrate serving as a semiconductor substrate, thereby forming the solid-state imaging elements 35a, 35b. The light-transmitting substrate 31 includes the inside electrodes 33, the terminal electrodes 34, and the traces 32 made of a light-transmitting conductive film. The solid-state imaging elements 35a and 35b and the traces 32 of the light-transmitting substrate 31 are overlapped so as to oppose each other. The solid-state imaging elements 35a and 35b are thereby electrically connected to the inside electrodes 33 connected to the traces 32. The light-transmitting substrate 31 is attached to the housing 50 made up of a lower lens barrel 41 and an upper lens barrel 42. The reference numeral 43 herein designates a light shielding wall, and the reference numeral 44 designates a lens, and the reference numeral 45 designates a diaphragm.

With this configuration, for example, traces are formed on the electric charge transfer units. Thus, trace routing can be facilitated while a reduction in an amount of received light is prevented.

Since the two imaging areas (light receiving areas) 36 are formed on a single semiconductor substrate, the imaging areas have a highly accurate base length. As a result, an extremely high accurate distance measuring characteristic can be provided.
As described above, it is possible to obtain a solid-state imaging device that exhibits a superior imaging characteristic, a highly accurate distance measuring characteristic, and high reliability of electrical connection obtained from high strength. Specifically, it is effective to apply the solid-state imaging device to a vehicle-mounted camera requiring distance measuring function and high reliability.

In the embodiments of the present invention, the integrated solid-state imaging elements including two imaging areas formed on a semiconductor substrate are described. However, when the present invention is applied to a solid-state imaging device including three imaging areas or more formed on a semiconductor substrate in an integrated fashion thereby exhibiting an improved imaging characteristic and an enhanced added value, it is possible to obtain a highly accurate, highly reliable solid-state imaging device and a method for manufacturing the same.

In this case, bumps may be formed by making electrode wiring pads around each imaging area. When a plurality of imaging areas are arranged, a method including adjusting areas for forming electrode wiring pads as necessary and forming the electrode wiring pads for each of the plurality of imaging areas may be also applicable.

In the embodiment, a glass substrate is used as a light-transmitting substrate. However, the material of the substrate is not limited to glass, and a light-transmitting resin substrate may be used.

To be more precise, the term "light receiving area" used in the present invention is defined to designate a light receiving area of a solid-state imaging element, i.e., an imaging area. For example, when a solid-state imaging element includes a plurality of pixels, it is not necessary to form regions between pixels by a light-transmitting conductive film so long as a light-transmitting conductive film is formed on the pixels.

In addition to indium tin oxide, tin oxide, zinc oxide, or the like, may be applied to the light-transmitting conductive film. A film forming technique using the photosensitive ITO paint described in the embodiments is effective as a method for forming a light-transmitting conductive film. However, another sputtering technique, a vacuum deposition technique, a sol-gel technique, a cluster beam deposition technique, a PLD technique, an inkjet plotting technique, and the like, are also applicable.

The present patent application is based on Japanese Patent Application (Application No. 2009-258226) filed on November 11, 2009, the entire contents of which are incorporated herein by reference.

### Industrial Applicability

According to the solid-state imaging device of the present invention, it is possible to route traces on light receiving areas by forming the traces from an optically transparent conductive pattern. A degree of freedom of trace routing is increased, and it is possible to reduce a size of a solid-state imaging device. Thus, the solid-state imaging device can be easily applied to a compact camera, etc. of a portable terminal, etc.

### Description of Reference Signs

1, 31: LIGHT-TRANSMITTING SUBSTRATE
2, 32: TRACE
3, 33: INSIDE ELECTRODE
4, 34: TERMINAL ELECTRODE
5, 35a, 35b: SOLID-STATE IMAGING ELEMENT
6, 36: IMAGING AREA (LIGHT RECEIVING AREA)
7: INSULATING SEALING RESIN
8: SOLDER BALL
9: PRINTED WIRING BOARD
10: UNDERFILL
11: LENS
12: LENS HOUSING
14: ELECTRICAL CONNECTION PORTION
15: METAL BUMP
43: LIGHT SHIELDING WALL
44: LENS
50: HOUSING

## Claims

1. A solid-state imaging device comprising:
a light-transmitting substrate including a terminal electrode for external connection, an inside electrode for bonding a solid-state imaging element, and a trace that connects the terminal electrode to the corresponding inside electrode; and
the solid-state imaging element which is placed such that a light receiving area opposes the light-transmitting substrate and which is connected to the inside electrode,
wherein the trace is made of a light-transmitting conductive film at least in a region opposing the light receiving area of the solid-state imaging element.

2. The solid-state imaging device according to claim 1,
wherein a region of a gap between the solid-state imaging element and the light-transmitting substrate except the light receiving area of the solid-state imaging element is filled with a sealing resin.

3. The solid-state imaging device according to claim 1,
wherein the light receiving area of the solid-state imaging element has a rectangular shape, and
wherein the trace obliquely runs across a corner portion of the rectangular shape.

4. The solid-state imaging device according to any one of claims 1 to 3,
wherein the terminal electrode is arranged along a side of the light-transmitting substrate.

5. The solid-state imaging device according to claim 4,
wherein the inside electrode is arranged along opposing two sides of the solid-state imaging element.

6. The solid-state imaging device according to any one of claims 1 to 5,
wherein the light-transmitting substrate is a glass substrate.

7. The solid-state imaging device according to any one of claims 1 to 3,
wherein at least an upper surface of the trace opposing the light receiving area of the solid-state imaging element is made of a light-transmitting conductive film, and
wherein in a region other than the light receiving area, the trace is made of a metallic film.

8. The solid-state imaging device according to any one of claims 1 to 7,
wherein the light-transmitting electrode is made of an indium tin oxide layer.

9. The solid-state imaging device according to any one of claims 1 to 8,
wherein a plurality of solid-state imaging elements are placed on the light-transmitting substrate.

10. The solid-state imaging device according to claim 9,
wherein the plurality of solid-state imaging elements are integrated on a single substrate, and
wherein in a region opposing the solid-state imaging elements, the trace is provided so as to oppose a trace area that surrounds the light receiving areas of the respective solid-state imaging elements.

11. The solid-state imaging device according to claim 10,
wherein each of the solid-state imaging elements comprises:
a photoelectric conversion unit comprising a photodiode; and
a charge transfer unit configured to transfer electric charges produced by the photoelectric conversion unit, and
wherein in the region opposing the solid-state imaging elements, the trace is formed in a region opposing the charge transfer units.

12. The solid-state imaging device according to claim 11,
wherein the light-transmitting substrate comprises:
an optical filter configured to permit transmission of light having a specific wavelength band; and
a light shielding film formed in a region corresponding to a boundary between a plurality of imaging areas.

13. A method for manufacturing the solid-state imaging device according to any one of claims 1 to 12, said method comprising:
a step of positioning a projecting electrode formed at a connection terminal of the solid-state imaging elements to the inside electrode of the light-transmitting substrate, and bonding the projecting electrode to the inside electrode by a conductive adhesive; and
a step of sealing the region of the solid-state imaging element except the light receiving area thereof.

14. The method for manufacturing the solid-state imaging device according to claim 13,
wherein the light-transmitting substrate comprises:
the glass substrate;
the optical filter which is formed on a surface of the glass substrate opposing an adhesive surface of the solid-state imaging element and which is configured to permit transmission of light having the specific wavelength band; and
the light shielding film formed in the region corresponding to the boundary between the plurality of imaging areas, and
wherein the sealing step comprises a step of sealing the region, except the light receiving area of the solid-state imaging element, with a photo-curable resin that causes a curing reaction at the transmission wavelength band of the optical filter after the bonding step.
